# EUROPEAN PATENT APPLICATION

(11) **EP 0 881 869 A2**
(43) Date of publication of application: **02.12.1998**
(21) Application number: 98303783.9
(22) Date of filing: 14.05.1998
(51) Int. Cl.: H05K 7/14, H05K 9/00

(54) **Electrical equipment practice**

(30) Priority: 30.05.1997 GB 9711322
(71) Applicant: NORTHERN TELECOM LIMITED, Montreal, Quebec H2Y 3Y4 (CA)
(72) Inventor: Hughes, Richard, Kanata, Ontario, K2M 1P9 (CA); Humphries, Darren, Sawbridgeworth, Hertfordshire, CM17 9NN (GB); Moore, Geoffrey, Kanata, Ontario,K2K 2C1 (CA); Linwood, Peter, Gt Dunmow, Essex, CM63 1PJ (GB); Pushelberg, Floyd, Nepean, Ontario, K2G 5NP (CA)
(74) Representative: Humphrey-Evans, Edward John

(57) **Abstract**

The present invention seeks to provide an improved method and apparatus for flexible construction of modular electrical card rack equipment. It provides individually EMC-shielded modules and backplane and lightweight equipment carrier for improved system installation and maintenance. Improved module guide means permits insertion and retention of modules within the carrier substantially at one edge of the modules.

## Description

### FIELD OF THE INVENTION

The present invention relates to electrical equipment practice and a system incorporating the same.

### BACKGROUND TO THE INVENTION

In many control systems, such as a telecommunications base station or a control system for a mainframe computer, electrical cards are slotted into racks. Circuitry for particular control systems is typically arranged on one or several such cards.

For example, typical telecommunications equipment for Central Office (CO) applications will comprise multi-shelf racking systems, each rack comprising one or more horizontal shelves arranged one above the other, and each shelf being capable of receiving multiple electronic circuit cards. Shelves provide both upper and lower guide slots, into which individual cards may be inserted, and vertical backplane connectors for inter-board communication. The circuitry-bearing surfaces of individual cards are typically not physically protected and are therefore susceptible to damage during insertion and removal. Connection to the backplane is typically via circuit board edge-connectors, or the function of backplane may be provided in the form of a set of distinct cables.

EMC enclosure of such systems is typically provided at the system, rack, or shelf level: metal shelf enclosures may be used which, in combination with metal circuit card front plates, combine to provide full enclosure of the cards in a rack. Where shelves are not completely filled with cards, blanking plates at front and/or rear, must be provided to complete the EMC enclosure; for inter-card protection within a single shelf and for intra-card EMC protection, metal cans may be affixed to the circuit boards to provide protection.

Such racking systems can be both inflexible and expensive. Furthermore, removal of circuit boards comprising elements of the overall EMC shielding compromises the shielding of the system as a whole and requires replacement with suitable EMC blanking plates.

It is also known from US Patent 4,460,265 ,"Modular Cell for Supporting and Protecting Electronic Cards", to construct EMC enclosures at the board or sub-shelf level, but typically these enclosures are designed such that all-around enclosure relies on juxtaposition of an adjacent enclosure to provide EMC protection on at least one side. For example, enclosures may provide protection to rear, top, bottom, and one side, protection to the other side requiring an adjacent similar enclosure, and protection to the front still reliant on the circuit board front plates. In such cases, card retaining guides are provided both at bottom and top inside the EMC enclosures. Insertion and removal of electronic circuitry remains at the circuit board level, individual circuit boards being slid in and out of the EMC enclosures for installation and maintenance: the EMC enclosures themselves are not removed with the boards.

It is also known to construct modules comprising EMC enclosures which require conductive gaskets and/or metalised tape at seams and connectors to provide adequate enclosure. However, EMC gaskets are expensive and difficult to handle.

Redesign of custom backplanes for new products is both expensive and time-consuming. Furthermore if a backplane is large and heavy, then installation and replacement are difficult and awkward. It is also difficult to reconcile cable routing and thermal requirements within the same system in a satisfactory manner.

### OBJECT TO THE INVENTION

The present invention seeks to provide an improved method and apparatus for flexible construction of modular electrical card rack equipment.

### SUMMARY OF THE INVENTION

According to a first aspect of the present invention, there is provided a modular enclosure system providing EMC shielding for electrical card rack equipment, comprising a module enclosure (M0) having a body (M1, M2, & M3) and a cover (M4) characterised in that the cover is adapted to slide with respect to the body, whereby to provide both structural strength and EMC shielding.

The invention also provides for a system for the purposes of digital signal processing which comprises one or more instances of apparatus embodying the present invention, together with other additional apparatus.

The preferred features may be combined as appropriate, as would be apparent to a skilled person, and may be combined with any of the aspects of the invention.

### BRIEF DESCRIPTION OF THE DRAWINGS

In order to show how the invention may be carried into effect, embodiments of the invention are now described below by way of example only and with reference to the accompanying figures in which:
Figure 1 shows an equipment carrier with a single module and backplane in place;
Figure 2 shows an equipment carrier with backplane in place;
Figure 3(a) shows an exploded view of the carrier and backplane assembly;
Figure 3(b) shows an cross-section of an example of the carrier guide means;
Figure 4 shows an assembled backplane;
Figure 5 shows an assembled module;
Figure 6 shows an exploded view of an example module.
Figure 7 shows a schematic perspective of a module illustrating air flow aspects.

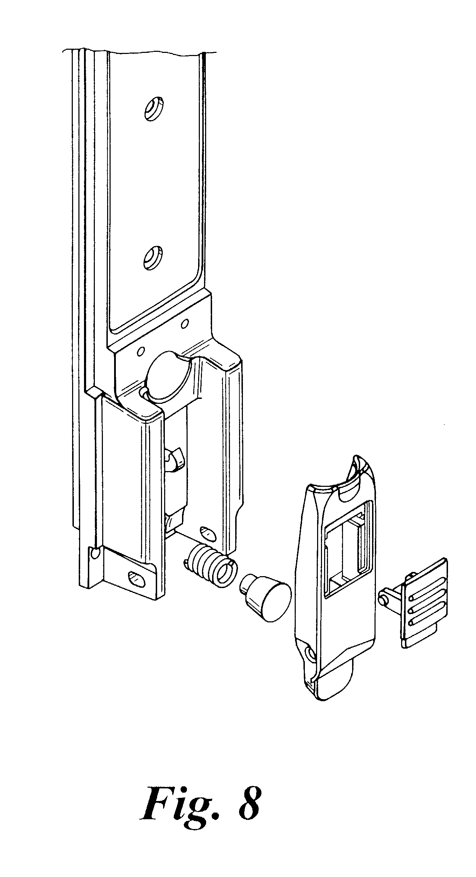

Figure 8 shows an exploded view of a specific module-locking mechanism.

In the description which follows, all reference to the specific orientation (e.g. "top", "bottom", "front", etc.) of apparatus described is with reference to the examples as shown in the figures and is not be interpreted as limiting.

### DETAILED DESCRIPTION OF INVENTION

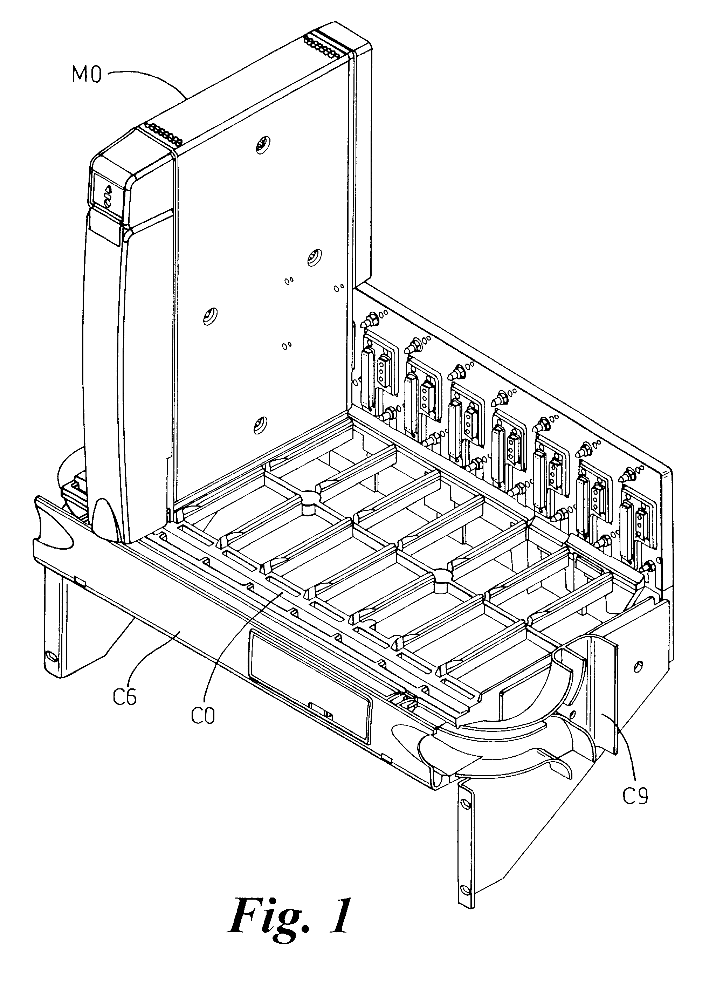

Figure 1 shows a perspective view of an assembled apparatus, comprising equipment carrier (C0), backplane (B0), and a single module (M0), each of which is described in more detail below.

The carrier (C0) is adapted to support both a backplane (B0) and a set of modules (M0) and provides an integral cable channel in front (C2).

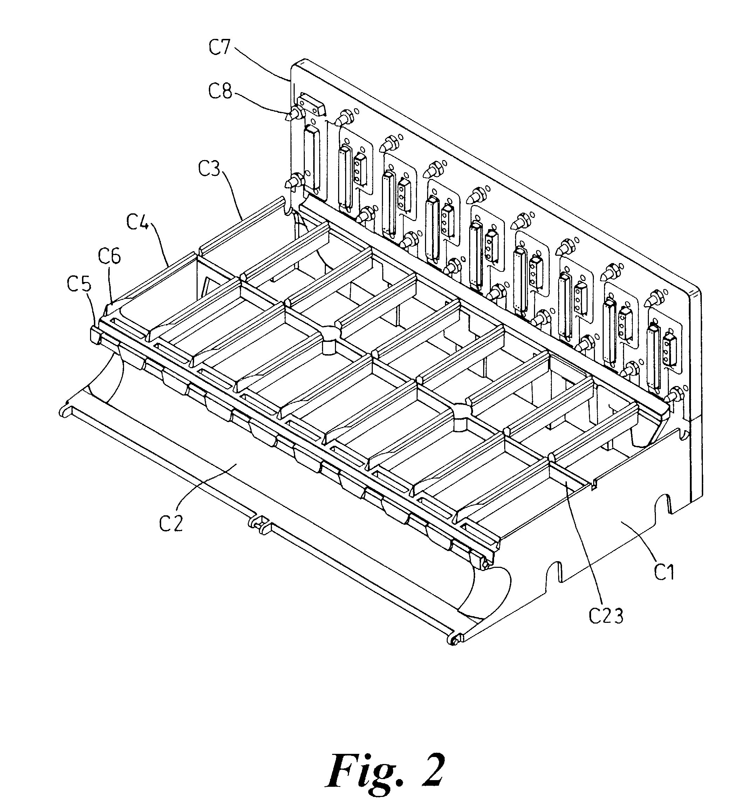

The carrier comprises an integral cable channel (C2) which may optionally be covered with a cable channel cover (C6). Figure 2 shows a perspective view of a carrier (C0) with attached backplane (B0), with the cable channel front cover (C6) removed to reveal the cable channel (C2).

Advantageously, the carrier may also comprise cable routing means (at the upper edge of the cable channel for example), whereby to guide and retain cables as they pass from the module to the cable channel. Such cable grips may beneficially be formed as an integral part of the carrier moulding.

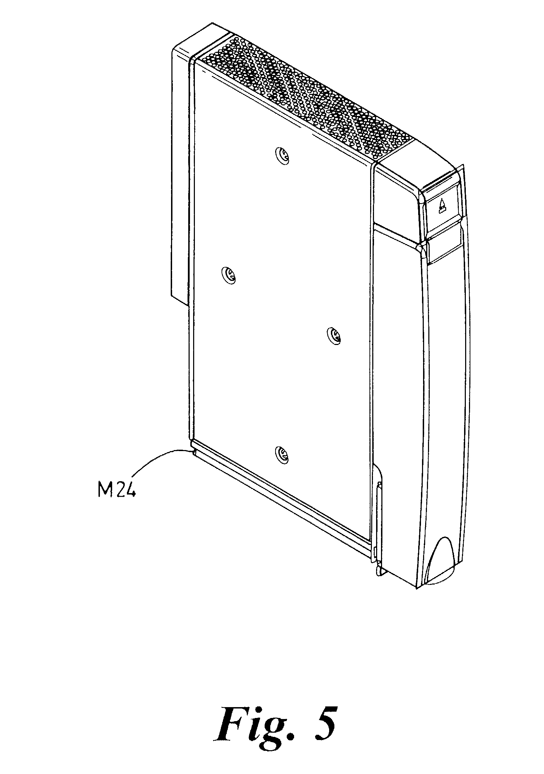

Figure 5 shows a perspective view of an example module. Each module is designed to meet pre-determined requirements with respect to physical dimensions, structural strength, EMC screening, power consumption, and heat dissipation.

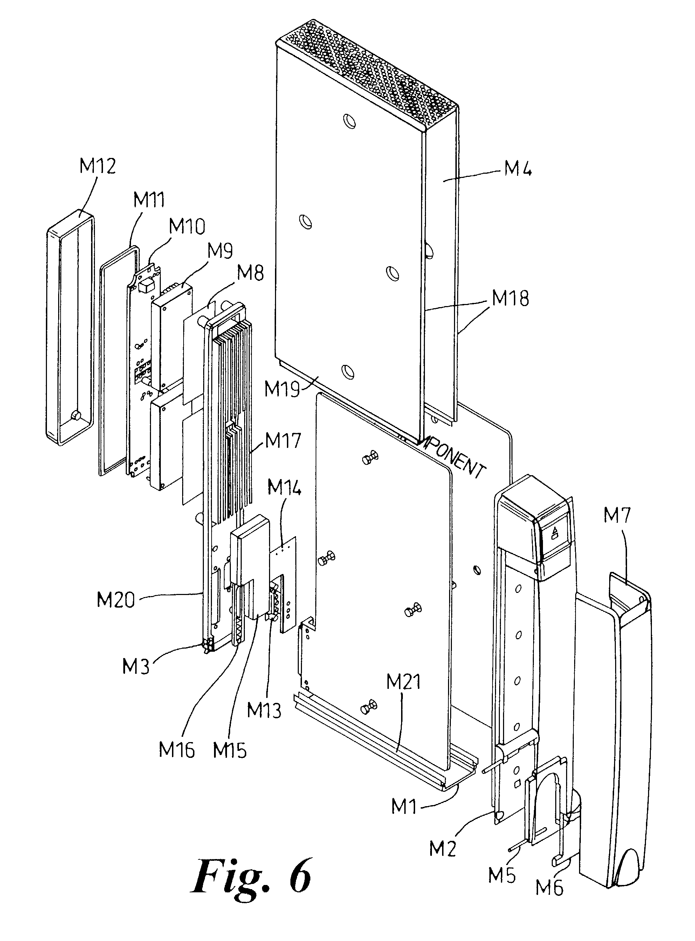

A first embodiment of a module in accordance with the present invention is shown in Figure 6. The module comprises a base plate (M1), a front plate (M2), a back plate (M3), a removable cover (M4), latch retaining means (M5), latch lever means (M6), front cover (M7) to enclose any front cabling, a Point-of-Use Power Supply assembly (in this example comprising thermal conduction pads (M8), the power supply itself (M9), printed circuit board (PCB) (M10), EMC gasket (M11), and power supply cover (M12) ), a power filter assembly (M13, M14, M15, & M16) to prevent noise from the module passing to the backplane, heat dissipation fins (M17) for cooling the power supply. The front plate (M2) may additionally comprise inserts for front connectors.

The base plate (M1), front plate (M2), back plate (M3), and module shell (M4) are all made of a material (for example formed, extruded, or die-cast metal) capable of providing EMC shielding for components contained within the module once assembled.

The die-cast front plate (M2) and back plate (M3) are each affixed to the extruded metal baseplate (M1) by suitable fixing means (for example screw-threaded fasteners) to form a rigid structure. The module shell (M4) is preferably constructed from a single sheet of metal and formed to provide the upper surface and both side surfaces of the module.

Inward-facing flanges (M18) are provided around front and rear edges of the module shell (M4). Grooves (M20), corresponding in size and position with the front and rear flanges of the removable cover (M4), are provided along the upper and side edges of both the frontplate (M2) and the backplate (M3) so that the flanges may engage in and be retained in said grooves.

Similarly, stepped flanges (M19) are provided extending first inwards then downwards from the lower edges of the module shell. A groove, corresponding in size and position with the downward-facing edges of the stepped flanges of the module shell (M4), is provided along each side of the upper face of the base plate (M1).

The flanges (M18) extending around front and rear edges of the module shell locate in the corresponding grooves (M20) by engaging the open ends of the flanges in one end of the grooves and sliding the removable cover along. On insertion, as the stepped flanges (M19) approach the corresponding grooves (M20) in the base plate (M1), the stepped flanges engage in the baseplate groove and, continuing the same sliding action, are pushed home to provide an EMC seal. For improved sealing, the flanges may be provided around the periphery with integral EMC contact points. This may, for example, be provided in the form of alternately bent fingers at the open edges of the flanges.

The ability to insert and remove the module shell in a single sliding motion in either case allows faster and simpler maintenance procedures by reducing or obviating the need for additional retaining fasteners (for example screw-threaded fasteners) to lock the module shell in place. Nevertheless, such fasteners may be added if required.

It has been found that, when the module shell is inserted in the assembly, the combination of flanges and grooves so formed provide, in combination, effective EMC seals around the edges of the module shell without need for introduction of an EMC gasket around the join. It is possible to achieve at least 40 dB using the method described above. This can be achieved using fingers, dimples, or gaskets, provided apertures between contact points are of appropriate size to provide required shielding. At some operating frequencies, for example 40 GHz, it may still be necessary to insert suitable EMC shielding gaskets to obtain adequate seal. The combination of grooves and flanges also provides added rigidity to the module enclosure so formed. The flanges themselves provide added rigidity to the module shell itself.

The baseplate (M1) and single module shell (M4) may be replaced by a set of panels, one or more of which are affixed to the front and back panels to provide structural rigidity, and one or more of which are removable and which, in combination, provide EMC shielding and structural rigidity. Similarly, the enclosure may be modified such that the removable cover also forms part of the frontplate or backplate.

Frontplate (M2) is configurable to meet a wide range of interface requirements including, for example, optical, electrical, and radio frequency interfaces. Cabling from such interfaces may be contained within the space substantially enclosed between the front plate (M2) the front cover (M7), the front cover being hinged at the upper edge to afford easy access to the cabling and interfaces when installed.

In a preferred embodiment, modules plugged into a backplane are designed to enable compliance to CISPR ("International Special Committee on Radio Interference") 22 Class "B" emission requirements for pedestal, wall mount, and rack mount forms of system packaging. This can be achieved using module cases with a nominal design shielding effectiveness of 40 dB.

The backplane module provides shielding for the bus and power wiring contained therein, which ensures a safety margin for the variance of emissions expected with numerous equipment line-up combinations, as well as anticipating the inclusion of third party modular equipment.

The shielded module cases allow effective use of shielded twisted pair and coaxial cables for external cable interfaces. Unshielded twisted pair cables may also be used subject to the limitations of proprietary magnetics circuitry available to suppress emissions.

The shielded module enclosures can provide compliance to the following immunity requirements: electrostatic discharge of 15 kV in Air and of 8 kV Contact; EFT of 1 kV on signal lines and of 2 kV on power lines; radiated field immunity to 10 V/m, modulated, at 100 kHz - 1 GHz; and conducted radio frequency immunity to 10 V common-mode, at 150 kHz - 100 MHz.

This modular packaging system comprises shielded unit enclosures interconnected by a wiring backplane which is also shielded and may comprise modular segments for certain applications. This topology has a unique set of electromagnetic containment requirements due to its extensive use of connectors which are exposed on its exterior and due to its reconfigurability.

The modular packaging system gives additional benefits in interference reduction over that obtained with conventional card cage construction inside of a shielded shelf. Partitioning of circuitry into shielded modules helps to eliminate interactions and coupling between the noisy and quiet parts of the system, and serves to contain the noise in the area where it is generated. Partitioning also shifts the lower cabinet resonances of the enclosed shelf up to a higher frequency range inside the individual modules, where the noise energy of integrated circuits is falling off and where cable coupling effects are weaker.

It should be noted that whilst EMC has been used loosely, EMC is intended to include three distinct types: Electro-Magnetic Interference (EMI), Radio Frequency Immunity (RFI), and Electro-Static Discharge (ESD) .

Priority has been assigned to EMI as it is generally the most difficult requirement to meet in a product that primarily uses digital techniques as opposed to analogue circuitry. The shielding provided for emission control will generally be more than adequate for RFI control. The filtering provided for copper I/O interface ports for emission control might be adequate for RFI but must be evaluated for individual cases.

For new modules embodying the present invention, an overall target Shielding Profile can be defined for the module, based upon anticipated product application and internal component technology and susceptibility, and circuitry operating frequencies. The Shielding Profile is based upon the allocated shielding level obtained from the EMI allocation or budget.

Materials are of concern mainly when extremely thin platings or coatings are used as a shield on a non-metallic base. Such coatings are not generally preferred unless robustness is proven and thickness and electrical conductivity is sufficient to contain magnetic near fields from integrated circuits and ESD discharge currents.

The ventilation screen chosen for modules is typically a triangular array (staggered hole pattern) of 5 mm diameter holes in a screen having 60% open area. This represents a compromise reached between EMC requirements and thermal design requirements for a nominal or basic module. The percentage of open area and the shape and arrangement of the holes may of course be varied according to the degree of shielding required.

A ventilation screen is preferably provided both on the upper and lower face of the module to maximise ventilation. EMI considerations will determine the maximum aperture size: it is desirable that no single aperture have its longest dimension greater than 1/20 of a wavelength at the frequency of the 10th harmonic of the fastest clock in the circuit being shielded. This simple rule of thumb is useful in determining hole sizes and seam fastener spacings.

The backplane module (B0) provides screened connectivity between modules within a shelf. The backplane interconnect bus (B2) is fabricated as a printed circuit. The bus module accepts power from the breaker interface panel and distributes a 48V supply to each module's power supply. Additionally the backplane interconnect bus may provide Asynchronous Transfer Mode (ATM), or other communications protocol, redundancy connectivity between shelves.

The backplane module is typically required to screen backplane data traffic and 48V power and provide crosstalk isolation between these respective lines. In a preferred embodiment, the backplane interconnect bus provides point-to-point connectivity between each module connector (B6) and a specific backplane connector (B7) to which a module providing communication switching functionality may be connected. Communication connectivity may also be provided between each module connector (B6) and inter-shelf connectors (B8) whereby to facilitate inter-shelf communication and functional redundancy between shelves.

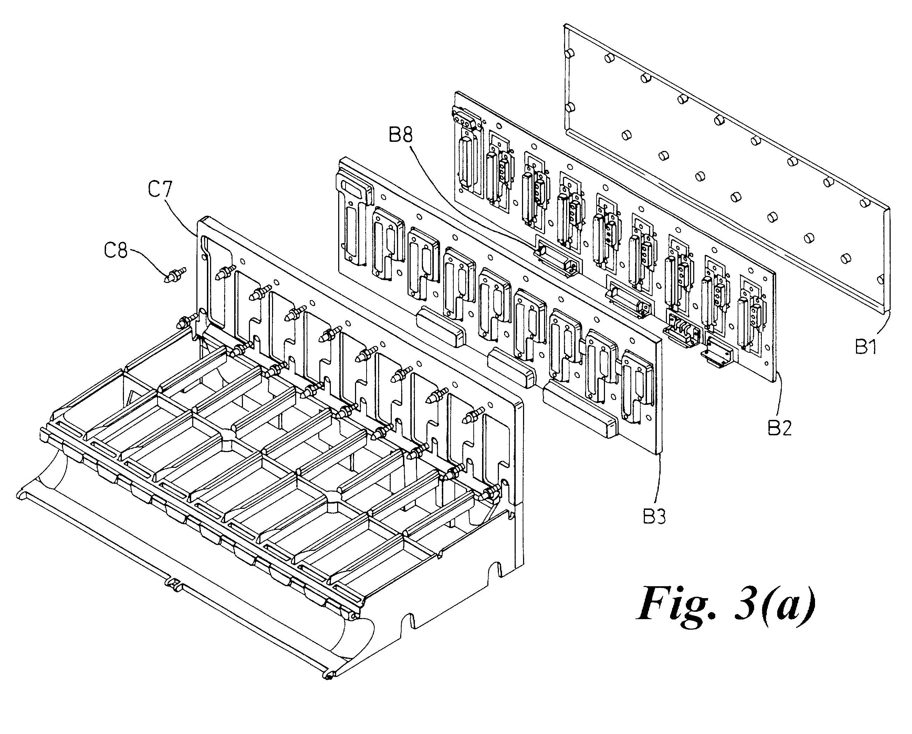

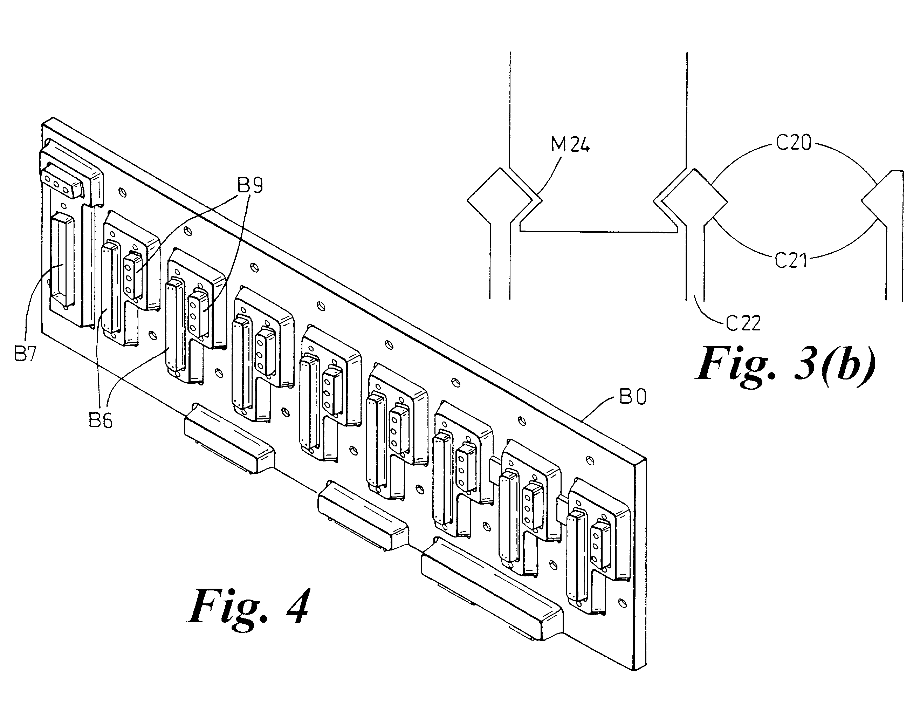

Backplane communication connectors (B6, B7, & B8) may be realised, for example, as D-type electrical connectors or similar bayonet-type connectors, as illustrated in Figure 3, or as optical connectors. This alows communication connection to be achieved through axial movement of modules as they are mounted in the carrier.

Unused but energised connector pins on the backplane interconnect bus can cause emissions problems. In the worst case scenario a clock harmonic could excite the pin at a quarter of the operating frequency resonance. Since the connector pins do not carry a clock signal, only random data, this problem is reduced. True symmetric random data at 214 Mb/s produces an emissions spectrum approximately 32 dB down on an equivalent clock as observed through the EMI measurement receiver bandwidth. When the data possesses asymmetry, or the encoding algorithm adds clock bits for clock recovery, or there are common mode clock signals resident on the random data, as is highly likely in some cases, then emissions could occur.

A module enclosure is an "empty box" adapted to facilitate deployment of electronic equipment. Each module has its own individual power supply with defined connection to the internal circuitry, and the module design is parametric with regard to EMC shielding, heat dissipation, and physical dimensions. The modular approach allows packaging of existing electronics (for example Original Equipment Manufacturer (OEM) equipment, or proprietary circuit board designs) within a uniform framework for easy incorporation in new products.

Each module provides EMC screening via a convoluted EMC wave guide (with optional edge fingers for improved contact) which also provides structural rigidity: the module construction provides sufficient stiffness without requiring use of additional board stiffeners.

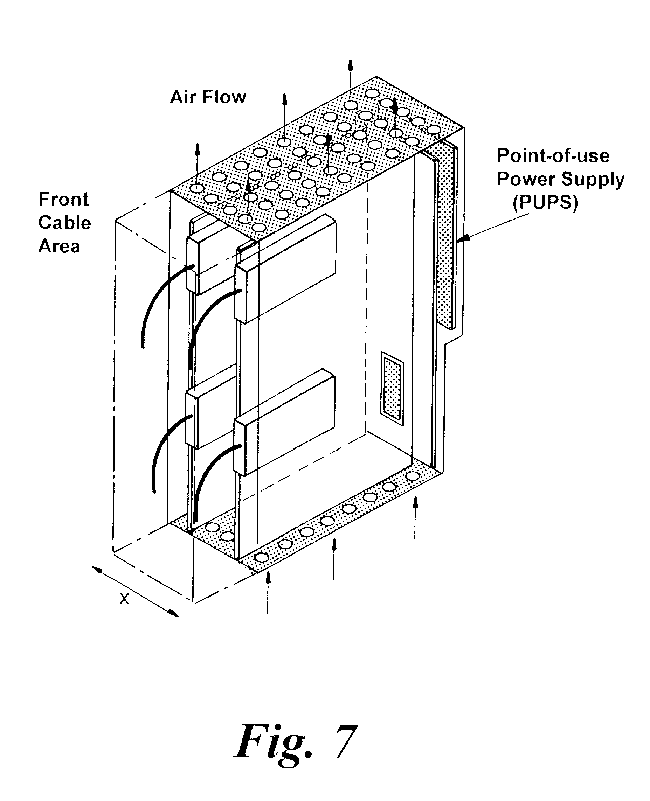

With reference to Figure 7, use of a standard module design also provides a defined thermal problem: each module has defined boundary conditions, dependent only upon the cooling method chosen, that are not significantly changed by modules surrounding it. Thermal design options allow for varying customer power from self-contained natural convection through to forced cooling, all consistent with EMC and safety requirements -- cooling paths are separate for different electronic functions. It is also possible to provide conduction cooling paths from hot components to the outer surfaces of modules if required for additional heat dissipation. This is also desirable at high circuit operating frequencies where provision of air ventilation holes in the enclosure would compromise EMC requirements.

The system is conducive to front-in-front-out or front-in-rear-out airflow cooling by adding or exchanging cooling and air-baffle means around the electronic modules.

Manufacture of such modules would be cost-effective design as a result of volume manufacture.

Having a modular system that is not defined by the internal electronics brings advantages of common alarm display and signalling strategy, common appearance for all products deployed, and common installation for all products deployed. A cosmetic cover (M7) protects any optional front interconnects, which protection is particularly important in the case of optical interconnects.

In a preferred embodiment, feed-through filters are employed to remove noise from the backplane power feed.

The module mounting mechanism provides single point mounting and locking to carrier.

Global market requirements (for example ETSI standards) for use in Central Office, Customer Premise, and Outside Plant Applications determine that an equipment carrier and any modules carried on it fit within a volume 280 mm deep by 450 mm wide. An aggregation height of 2000 mm permits modules to be stacked four-high within suitable racking within the 2100 mm height permitted by Central Office requirements, whilst still allowing space for appropriate cable management and airflow management. The modules are integral multiples of 50 mm wide. Wider modules may be required where third party circuitry or component density precludes their containment within a minimum-width module. Such modules may conveniently be, but need not be, integer multiples of the minimum module width.

The dimensions of specific modules and grouping of modules may be varied to produce modules of other sizes for different applications whilst retaining the attributes of modularity, interchangeability, and ease of use within each specific size.

Figures 3(a) and 4 show an exploded view and an assembled view respectively of a backplane in accordance with the present invention. The backplane comprises an EMC enclosed construction in its own right, though typically of distinct dimensions and employing distinct retaining means from those of modules located on the carrier. EMC protection is provided by a two-part shield (B1 & B3).

The carrier and backplane assembly incorporates features to retain the backplane module (B0) to the carrier (C0) and to ensure module-to-backplane connection. Metal dowels (C8) are used to attach the backplane module (B0) to an supporting portion (C7) of the carrier (C0). By ensuring that the metal dowels project from the supporting portion (C7) of the carrier further than do the connectors (B6, B7), the dowels also serve as centring means to guide modules onto the connectors (B6) and to provide electrostatic discharge point for modules prior to connection.

In a preferred embodiment the modules are located on top of the carrier but other options are possible: for example, modules may be suspended from the carrier.

The carrier is preferably constructed from a cheap, relatively rigid material (for example polycarbonate plastics) which provides sufficient structural rigidity to meet typical safety regulations and customer equipment requirements. The light weight of the carrier and the reduced-height backplane allow rapid, single person, installation and removal.

Integral cable routing conduits (C2) are provided as part of the carrier. The routing conduits may provide separation for fiber and copper, if necessary, and allow connector and cable guiding without impinging on airflow. Conduits (C9) may also be provided for vertical or inter-carrier guiding of cables if needed.

In existing systems, guide rails are provided both on lower and upper carrier members, co-operatively to constrain lateral movement of the component circuit boards. Similarly, vertical movement of component circuit boards is constrained co-operatively by the upper and lower carrier members: the lower carrier member typically provides supporting means in the form of an upwardly facing surface between the lower guide rails; the upper carrier member typically provides restraining means in the form of a downwardly facing surface between the upper guide rails.

A carrier in accordance with the present invention comprises retaining means substantially located, in operation, at a single edge of a retained module, whereby modules are constrained in both the lateral and vertical planes thereby removing the need for the two distinct upper and lower carrier members as described above.

The retaining means comprises straight, parallel guides (C3, C4) extending substantially from front to rear of the carrier. Each guide comprises an upper weight-bearing surface (C20) which restricts downward movement of modules once engaged, and a lower restraining surface (C21) which prevents upward movement of a module once engaged. Neither surface need be horizontal; two weight-bearing surfaces (C20) and two restraining surfaces (C21) are provided by a single guide to support adjacent modules; at the end of each carrier, where only one module is retained by the guide, a single weight-bearing surface (C20) and a single restraining surface (C21) are provided by a single guide.

Complementarily-shaped guide grooves (M24) are provided along two side of the each module baseplate (M1).

A strengthening member (C22) below the bearing surface provides rigidity in the vertical plane to prevent sagging of the guide along its length. Where appropriate, for example where the guides are long, additional strengthening members (C23) may be provided both to maintain the spacing between, and to prevent lateral deformation of, the guide rails.

As Figures 1, 2 and 3(a) show, the guide means need not extend continuously from front to rear of the carrier; sufficient that enough guide means be provided to retain and guide modules in the necessary planes. For example, Figure 3(a) shows guide means in two distinct sections (C3, C4). Advantageously, the guides may be tapered (C6) at the end from which modules are inserted. This provides a wider initial access to guide modules onto the retaining guides thereby facilitates easier insertion of modules.

The guide means (C3, C4) on the carrier and the corresponding guide grooves (M24) on the modules provide initial module alignment, and retain modules in the carrier once initial engagement has been provided, so as to prevent modules from tilting during installation and removal.

The use of the guide and guide-groove (M24) mechanism permits use of a single front-mounted finger-operable latch on each module to lock and unlock each module on the carrier. The latch is operable to provide, in a first movement, axial force to engage the module and, in a second movement, axial force to disengage the module.

Power distribution may be achieved either internally through the backplane or externally via busbars.

The present invention provides a highly adaptable equipment practice: the carrier and backplane can be deployed as pedestal mount or wall-mount for Customer Premises Equipment (CPE), and can be adapted to 19" rack, NEBS, ETSI (or any other rack) for Central office (CO) applications. The apparatus can be supplied with power from a separate power shelf (for example, BIP) in a rack or shelf expanded with AC unit at either end and provided to individual modules via suitable power connectors (B9), for example multi pin bayonet-type connectors which allow electrical contact to be made during axial movement of modules during mounting in the carrier.

The provision of a switch (or router) module, preferably at one end of carrier, facilitates simple plug-and-play operation, whereby the apparatus can be configured at will, though limited by the capacity of the carrier and the backplane bandwidth. A distinctive connector (B7) shape, size, or position may be utilised to ensure correct positioning of a special module (for example the switch module) to prevent insertion of such a module in an inappropriate module position on the carrier. Alternatively, distinct positioning of the centring dowels (C8) may be used to achieve the same purpose.

The apparatus permits use of low-density connectors for interconnection to the backplane. The apparatus provides a common backplane interconnect protocol for every module, and supports self-discovering modules for ease of insertion and reconfiguration. The system can grow to meet changing customer demands by simple addition and removal of modules without the need for system re-wiring changes, etc.

Taken in combination, the improvements offered by the present invention facilitate rapid time-to-market.

Any range or device value given herein may be extended or altered without losing the effect sought, as will be apparent to the skilled person for an understanding of the teachings herein.

## Claims

1. A modular enclosure system providing EMC shielding for electrical card rack equipment, comprising a module enclosure (M0) having a body (M1, M2, & M3) and a cover (M4) characterised in that the cover is adapted to slide with respect to the body, whereby to provide both structural strength and EMC shielding.

2. A modular enclosure system as claimed in claim 1 further characterised in that structural dependence of the enclosure on enclosed circuit boards is reduced.

3. A modular enclosure system as claimed in claim 1 further characterised in that sliding engagement means comprises complementary flanges and grooves.

4. A modular enclosure system as claimed in claim 1 further characterised in that sliding engagement means comprises complementary flanges and grooves and wherein flanges are provided with fingers for improved EMC shielding.

5. A modular enclosure system as claimed in claim 1 further characterised in that the enclosure comprises ventilation holes.

6. A modular enclosure system as claimed in claim 1 further characterised in that it comprises integral power supply means (M8, M9, M10, & M11).

7. A modular enclosure system as claimed in claim 1 further characterised in that it comprises a backplane connector (M16) positioned such that EMC leakage from connector joints is contained within the module enclosure.
